# EUROPEAN PATENT APPLICATION

(11) **EP 4 757 507 A1**
(43) Date of publication of application: **10.06.2026**
(21) Application number: 24218376.2
(22) Date of filing: 09.12.2024
(51) Int. Cl.: H05K 3/00, H05K 3/32, H05K 3/46, H05K 3/36

(54) **METHODS FOR ELECTRICAL CONNECTION OF A FIRST CIRCUIT BOARD TO A SECOND CIRCUIT BOARD**

(71) Applicant: Lisa Dräxlmaier GmbH, 84137 Vilsbiburg (DE)
(72) Inventor: Grudzien, Szymon, 30-864 Kraków (PL); Orzechowski, Sebastian, 43-180 Orzesze (PL); Murgott, Krzysztof, 85716 Unterschleißheim (DE)

(57) **Abstract**

The disclosure relates to a method for electrical connection of a first circuit board (110) to a second circuit board (120) by single-side welding or by double-side welding. A first circuit board and a second circuit board is provided, wherein at least one metal pad (311) of the first circuit board (110) is overlying at least one metal pad (311) of the second circuit board (120) when the first circuit board (110) is placed on top of the second circuit board (120). The single-side welding method comprises: electrically connecting (414) two leads (131, 132) of a welding machine (130) to a first part (312) and a second part (313) of the at least one metal pad (311) of the first circuit board (110); and welding the metal pad (311) of the first circuit board (110) to the metal pad (311) of the second circuit board (120) by activating a welding machine (130). The double-side welding method comprises: electrically connecting (424) two leads (131, 132) of a welding machine (130) to part of the at least one metal pad (311) on top of the first circuit board (110) and part of the at least one metal pad (311) on bottom of the second circuit board (120); and welding the metal pad (311) of the first circuit board (110) to the metal pad (311) of the second circuit board (120) by activating the welding machine (130).

## Description

### TECHNICAL FIELD

The disclosure relates to methods for electrical connection of a first circuit board to a second circuit board by single-side or double-side welding. In particular, the disclosure relates to FPC (Flexible Printed Circuit Board) to FPC or rigid PCB (Printed Circuit Board) direct connection with welding.

### BACKGROUND

Typical solutions available on the market for connecting an FPC to another PCB which can be rigid or flexible are based on the following techniques. 1) A PCB is designed as a rigid-flexible PCB. This solution is expensive and limited by single PCB size. 2) A semi-flexible PCB with milled out portions is used to provide a flexible connection between two rigid parts. This solution is also expensive and limited by single PCB size. 3) Dedicated connectors or cables can be used. This solution is limited by geometry and affected by price related to extra parts such as connectors or sockets or cables if necessary. 4) Soldering provides a cheap solution based on bare material application but is sensitive for cracks caused by mechanical strains and materials extension according to temperature coefficients characteristic for each material.

### SUMMARY

It is the object of this disclosure to provide a solution for connecting an FPC to another PCB which can be rigid or flexible without the above-described disadvantages. In particular, it is an object of the disclosure to provide a solution for connecting FPC to FPC or FPC to rigid PCB in a cheap, robust and efficient way.

This object is achieved by the features of the independent claims. Further implementation forms are apparent from the dependent claims, the description and the figures.

To overcome the above-described problems the disclosure presents a technique by which the first PCB (flexible) can be overlapped with a (second) flexible PCB (FPC) or a rigid one. Both two PCBs can be welded together in an area of mating pads with a spot-welding machine. Since copper is a material feasible for being welded, the process may be performed without any external materials. Hence, no extra layers on PCBs may be required. A standard stackup may be sufficient.

The solution described in this disclosure provides the following advantages: The solution can be implemented space-efficient by not using third party connectors. By using bare material instead of off-the-shelf components, the solution is cheaper and more environment-friendly, i.e., no single component production process behind and easy welding process in final application. Because of the character of the connection, i.e. by using welded connection of the same materials, e.g. copper, the relaxation of mating surfaces (caused by different extension temperature coefficient for different materials) can be realized without cracks and strains.

The presented solution can be implemented in various applications where flexible PCBs are used. For example, flexible PCBs that have always an interface to rigid master boards, e.g. applications in ambient lighting projects, charge ports, etc. Moreover, the solution represents a technology of connection between PCBs so it can be used also in other applications where multi-board systems are used, e.g., power distribution networks, lighting systems, HV Batteries, etc. The presented techniques can also be used for FPC-to-FPC connection, for example if the limit of single FPC length is reached.

In comparison to state of the art the solution described in this disclosure is respectively: cheaper and smaller than solutions with extra components (such as connectors, cables), much cheaper than off-the-shelf rigid-flex PCBs solution. Moreover, rigid-flex stackups generate some design limitations like using of buried and blind vias which can be avoided by the solution presented in this disclosure. The disclosed solution is more robust against cracking than direct soldering.

In this disclosure FPCs and rigid circuit boards like PCBs are described.

An FPC is a type of circuit board that can bend without cracking, breaking or otherwise sustaining damage. FPCs are distinguished from rigid circuit boards (or PCBs) by their physical characteristics. Rigid circuit boards are stiff and rigid. FPCs, on the other hand, are flexible.

A printed circuit board (PCB) is a non-conductive material with conductive lines printed or etched. Electronic components are mounted on the board and the traces connect the components together to form a working circuit or assembly. In comparison to FPCs which are flexible, PCBs are rigid. When a PCB is described herein as being flexible, an FPC is meant.

According to a first aspect, the disclosure relates to a method for electrical connection of a first circuit board to a second circuit board by single-side welding, the method comprising: providing a first circuit board comprising at least one metal layer embedded within a plurality of cover layers, the at least one metal layer comprising at least one metal pad for an electrical connection of the first circuit board; providing a second circuit board comprising at least one metal layer embedded within a plurality of cover layers, the at least one metal layer comprising at least one metal pad for an electrical connection of the second circuit board; wherein the at least one metal pad of the first circuit board is overlying the at least one metal pad of the second circuit board when the first circuit board is placed on top of the second circuit board; placing the first circuit board on top of the second circuit board; electrically connecting two leads of a welding machine to a first part and a second part of the at least one metal pad of the first circuit board; and welding the at least one metal pad of the first circuit board to the at least one metal pad of the second circuit board by activating the welding machine.

Such a method provides a solution for connecting FPC to FPC or FPC to PCB in a cheap, robust and efficient way. The method can be implemented space-efficient by not using third party connectors. By using bare material instead of off-the-shelf components, the method is cheaper and more environment friendly. By using welded connection of the same materials, e.g. copper, the relaxation of mating surfaces caused by different extension temperature coefficient for different materials can be realized without cracks and strains.

According to a second aspect, the disclosure relates to a method for electrical connection of a first circuit board to a second circuit board by double-side welding, the method comprising: providing a first circuit board comprising at least one metal layer embedded within a plurality of cover layers, the at least one metal layer comprising at least one metal pad for an electrical connection of the first circuit board; providing a second circuit board comprising at least one metal layer embedded within a plurality of cover layers, the at least one metal layer comprising at least one metal pad for an electrical connection of the second circuit board; wherein the at least one metal pad of the first circuit board is overlying the at least one metal pad of the second circuit board when the first circuit board is placed on top of the second circuit board; placing the first circuit board on top of the second circuit board; electrically connecting two leads of a welding machine to part of the at least one metal pad on top of the first circuit board and part of the at least one metal pad on bottom of the second circuit board; and welding the at least one metal pad of the first circuit board to the at least one metal pad of the second circuit board by activating the welding machine.

Such a method provides a solution for connecting FPC to FPC in a cheap, robust and efficient way. The first FPC can be overlapped with a (second) FPC. Both two FPCs can be welded together in an area of mating pads with a spot-welding machine. Since copper can be used for the metal pads and copper is a material feasible for being welded, the method may be performed without any external materials. Hence, no extra layers on FPCs are required. A standard stackup may be sufficient.

In an exemplary implementation of the method according to the first aspect, activating the welding machine enables a temporary current flow from a first lead to a second lead of the welding machine via the at least one metal pad of the first circuit board and the underlying at least one metal pad of the second circuit board, the current flow welding the at least one metal pad of the first circuit board to the at least one metal pad of the second circuit board.

By such current flow, an efficient, robust and stable welding connection of the first circuit board with the second circuit board can be achieved when using single-side welding.

In an exemplary implementation of the method according to the second aspect, activating the welding machine enables a temporary current flow from a first lead to a second lead of the welding machine via the at least one metal pad of the first circuit board and the at least one metal pad of the second circuit board, the current flow welding the at least one metal pad of the first circuit board to the at least one metal pad of the second circuit board.

By such current flow, an efficient, robust and stable welding connection of the first circuit board with the second circuit board can be achieved when using double-side welding.

In an exemplary implementation of the method according to the first or second aspect, the first circuit board is placed directly on top of the second circuit board without any intermediate component in between.

Such a direct placement can be easily provided, there is no need for third-party intermediate components.

In an exemplary implementation of the method according to the first or second aspect, the welding comprises resistive or inductive welding.

These welding processes can be used for long production runs and highly automated processes. They can be very fast processes, as a lot of power can be transferred to a localized area, so the faying surfaces can melt very quickly and can be pressed together to form a continuous weld.

Resistive welding is a welding process in which metal parts in contact are permanently joined by heating them with an electric current, melting the metal at the joint. Inductive welding is a form of welding that uses electromagnetic induction to heat the workpiece. The welding machine contains an induction coil that is energized with a radio-frequency electric current which generates a high-frequency electromagnetic field that acts on the workpiece.

In an exemplary implementation of the method according to the first or second aspect, the leads electrically contact the metal pads via access holes, in particular circular access holes in the cover layers of the respective circuit board, the access holes being fitted to a shape of the respective leads of the welding machine. These access holes may have been fabricated during production process of the circuit boards.

In these access holes the leads of the welding machine can intervene and transmit the current for the welding process to the metal pads of the circuit boards.

In an exemplary implementation of the method according to the first or second aspect, a size of the access holes is same or different for two of the access holes.

This provides a flexible design for different or same sized leads of the welding machine.

In an exemplary implementation of the method according to the first or second aspect, placing the first circuit board on top of the second circuit board comprises: placing a bottom surface of the first circuit board on a top surface of the second circuit board.

This allows to directly place the first circuit board onto the second circuit board to provide a reliable and stable welding connection.

According to a third aspect, the disclosure relates to an assembly of a first circuit board electrically connected to a second circuit board, the assembly being obtained by a method according to the first or second aspect.

Such an assembly provides a stable and robust welding connection that can be realized without cracks and strains.

In an exemplary implementation of the assembly according to the third aspect, the first circuit board is a flexible circuit board; and the second circuit board is a flexible or rigid circuit board.

Such assembly can be efficiently manufactured allowing the first circuit board to be flexible and the second circuit board to be either flexible or rigid.

In an exemplary implementation of the assembly according to the third aspect, the assembly comprises: at least one welding connection between at least one metal pad of the second circuit board and at least one metal pad of the first circuit board which is overlaying the at least one metal pad of the second circuit board.

Such connection can be produced by using bare material instead of off-the-shelf components, it can be produced cheaper and more environment-friendly.

### BRIEF DESCRIPTION OF THE DRAWINGS

Further examples will be described with respect to the following figures, in which:
Fig. 1 shows a schematic diagram of single-side welding 100 by using a single-side welding machine 130 according to the disclosure;
Fig. 2 shows a schematic diagram of double-side welding 200 by using a double-side welding machine 130 according to the disclosure;
Fig. 3a/b/c shows a side view, a bottom view and a top view of an FPC according to an embodiment;
Fig. 4a shows a schematic diagram of a method 410 for electrical connection of a first circuit board to a second circuit board by single-side welding according to the disclosure; and
Fig. 4b shows a schematic diagram of a method 420 for electrical connection of a first circuit board to a second circuit board by double-side welding according to the disclosure.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. Further, it is understood that the features of the various exemplary aspects described herein may be combined with each other, unless specifically noted otherwise.

The following embodiments are related to two PCBs connection- flexible one (FPC) to flexible one (FPC) or flexible one (FPC) to rigid one. The thickness, stackup and number of layers for rigid PCB is not a limiting parameter. Embodiments of the invention described in the following are related to direct connection, no intermediate, third-party component is necessary. Embodiments of the invention described in the following are related to realization of the connection with bare material, only tooling is required.

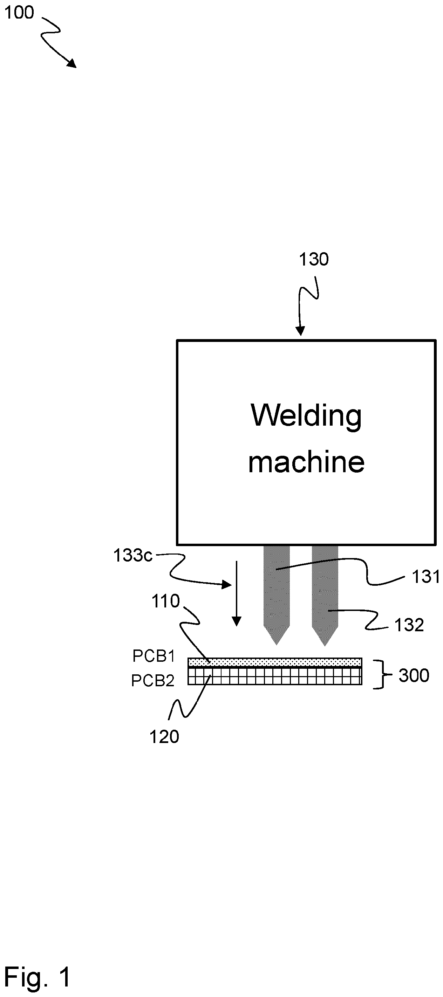

Fig. 1 shows a schematic diagram of single-side welding 100 by using a single-side welding machine 130 according to the disclosure.

A first type of welding machine 130 is shown in Figure 1, also referred to as single side spot welding machine, which can be used for single-side welding. The welding machine 130 comprises two leads 131, 132 which can be moved onto the top side of a first circuit board 110 to initiate a current flow through metal pads of the first circuit board, thereby welding the first circuit board to the second circuit board when the first circuit board 110 is placed on top of the second circuit board 120 such that the metal pads of the first circuit board 110 are overlaying the metal pads of the second circuit board 120. An electrical (and mechanical) connection between the first and second circuit boards 110, 120 can be made by resistive or inductive welding.

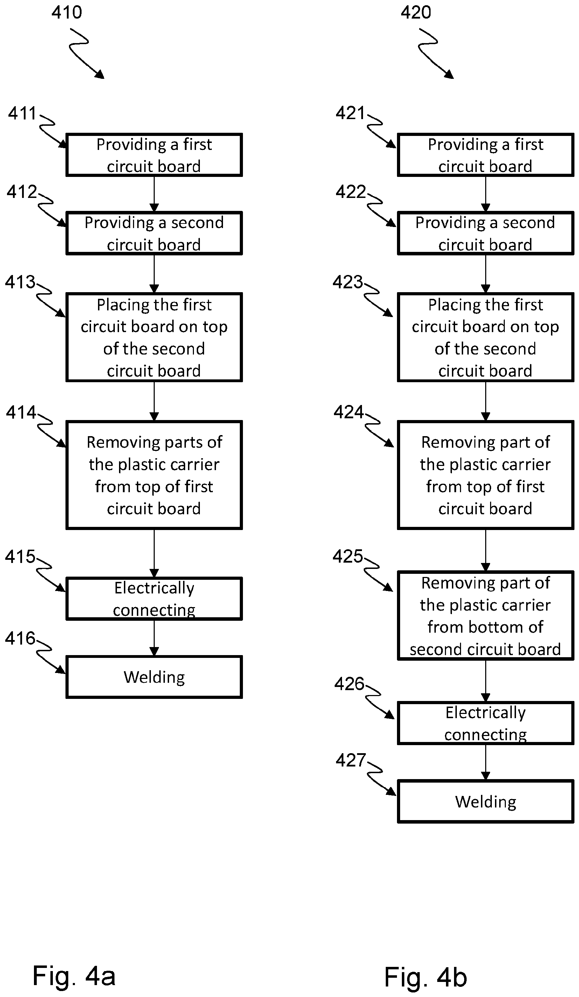

A method 410 for electrical connection of a first circuit board 110 to a second circuit board 120 by single-side welding 100 which is based on the scenario shown in Figure 1 is described below with respect to Figure 4a.

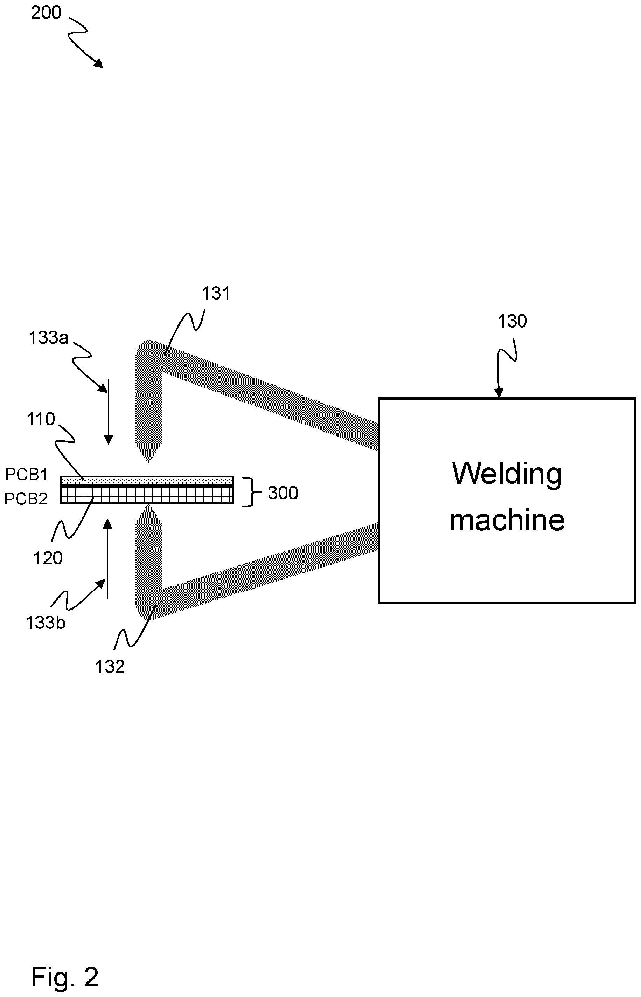

Fig. 2 shows a schematic diagram of double-side welding 200 by using a double-side welding machine 130 according to the disclosure.

A second type of welding machine 130 is shown in Figure 2, also referred to as double side welding machine, which can be used for double-side welding. The welding machine 130 comprises two leads 131, 132 which can be moved onto the top side of the first circuit board 110 and the bottom side of the second circuit board 120 to initiate a current flow through metal pads of the first circuit board, thereby welding the first circuit board to the second circuit board when the first circuit board 110 is placed on top of the second circuit board 120 such that the metal pads of the first circuit board 110 are overlaying the metal pads of the second circuit board 120. An electrical (and mechanical) connection between the first and second circuit boards 110, 120 can be made by resistive or inductive welding.

A method 420 for electrical connection of a first circuit board 110 to a second circuit board 120 by double-side welding 200 which is based on the scenario shown in Figure 2 is described below with respect to Figure 4b.

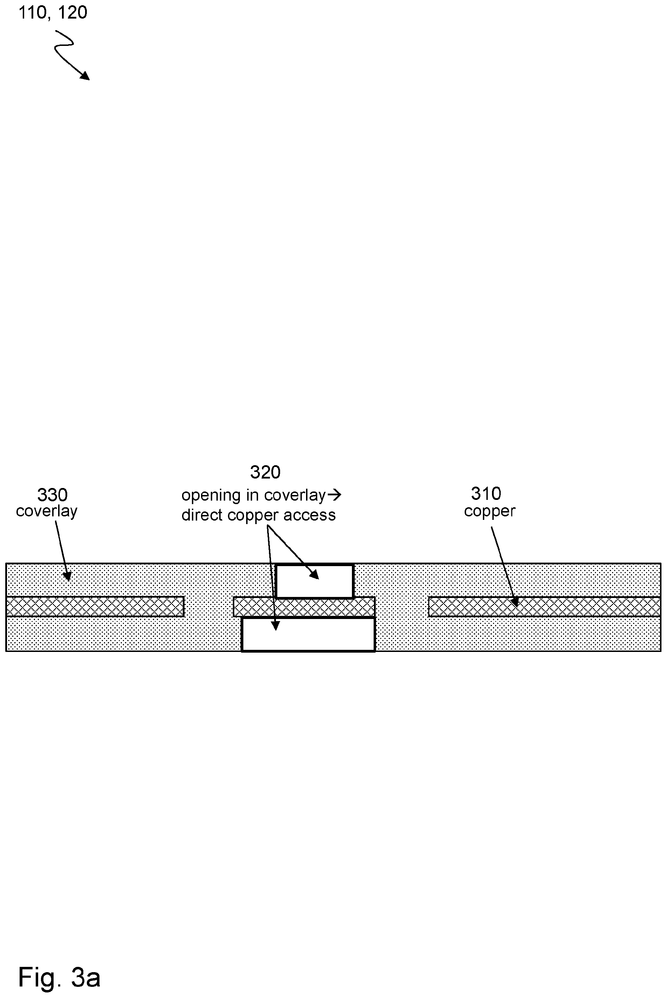

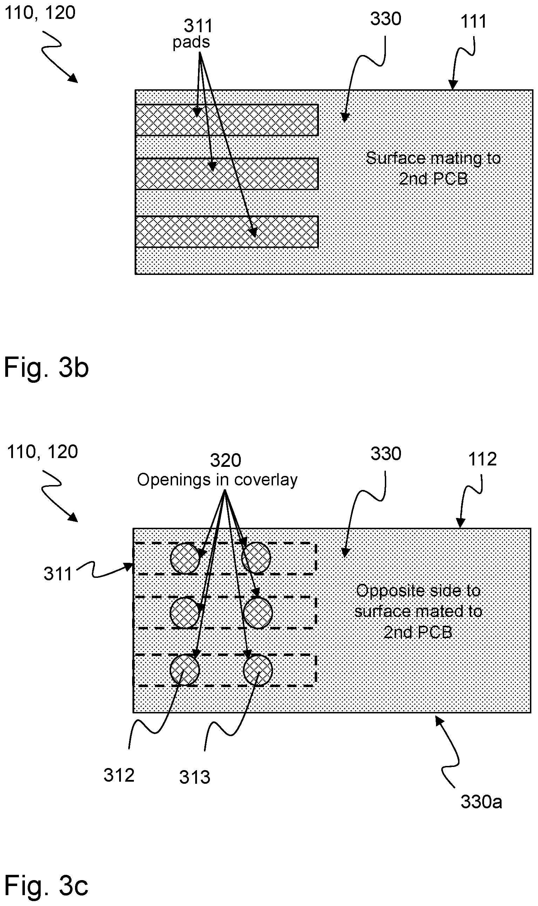

Fig. 3a/b/c shows a side view, a bottom view and a top view of an FPC according to an embodiment. The FPC can be the first circuit board 110 or the second circuit board 120 as shown in Figures 1 and 2.

The PCBs 110, 120 may be prepared as follows:
Both, FPC and FPC or rigid PCB which shall be welded together should have matching overlying pads 311. Additionally, FPC which shall be directly touched by welding machine 130 should have access holes 320 in coverlay 330 on opposite side to pads 311. The openings 320 for welding tool (leads 131, 132) may be circular and as small as possible, for example fitting to the leads 131, 132 of the welding machine 130.

Figure 3a shows a side view of FPC, Figure 3b shows a bottom view (matching surface to second PCB) of FPC, and Figure 3c shows a top view (surface welding machine will be attached to) of FPC.

When using dual-side welding machine only two FPCs can be welded together and both of them may be prepared according to Figure 3a/b/c.

When using single side welding machine both FPC-to-FPC and FPC-to-rigid PCB connections are possible. In these both two cases only one FPC may be prepared according to Figure 3a/b/c. The second PCB may be equipped with mating pads to first PCB.

The number of openings 320 in coverlay 330 to attach welding machine 130 can be, for example:
1. Minimum 1 per each single connection if dual side welding machine (see Figure 2) is used;
2. Minimum 2 per each single connection if single side welding machine (see Figure 1) is used;
3. Number of welding spots (and corresponding openings 320 in coverlay 330) can be extended according to available space (area of each single pad 311) and required pulling force.

Fig. 4a shows a schematic diagram of a method 410 for electrical connection of a first circuit board 110 to a second circuit board 120 by single-side welding 100 according to the disclosure.

The method 410 is based on the scenario shown in Figure 1 where a single-side welding machine 130 is used for single-side welding 100.

The method 410 comprises: providing 411 a first circuit board 110 (see Figure 1) comprising at least one metal layer 310 (as shown in Figure 3a) embedded within a plurality of cover layers 330 (see Figure 3a, named here as coverlay 330), the at least one metal layer 310 comprising at least one metal pad 311 (as shown in Figure 3b) for an electrical connection of the first circuit board 110. The cover layers 330 can also be named as non-conductive cover layers or non-conductive external layers.

The method 410 comprises: providing 412 a second circuit board 120 (see Figure 1) comprising at least one metal layer 310 (as shown in Figure 3a) embedded within a plurality of cover layers 330 (see Figure 3a, named here as coverlay 330), the at least one metal layer 310 comprising at least one metal pad 311 (as shown in Figure 3b) for an electrical connection of the second circuit board 120. The first circuit board 110 and the second circuit board 120 are such that the at least one metal pad 311 of the first circuit board 110 is overlying the at least one metal pad 311 of the second circuit board 120 when the first circuit board 110 is placed on top of the second circuit board 120. As mentioned above, the cover layers 330 can also be named as non-conductive cover layers or non-conductive external layers.

The method 410 comprises: placing 413 the first circuit board 110 on top of the second circuit board 120.

The method 410 comprises: electrically connecting 414 two leads 131, 132 of a welding machine 130 (as shown in Figure 1) to a first part 312 and a second part 313 (shown in Figure 3c) of the at least one metal pad 311 of the first circuit board 110. Both parts 312, 313 are located at top of the first circuit board 110 as can be seen from Figures 1 and 3c.

The method 410 comprises: welding 415 the at least one metal pad 311 of the first circuit board 110 to the at least one metal pad 311 of the second circuit board 120 by activating the welding machine 130. Activating the welding machine results in a current flowing from the first lead 131 to the second lead 132 via the first and second circuit boards 110, 120. This results in a welding connection between the first and second circuit boards 110, 120.

Activating the welding machine 130 enables a temporary current flow from a first lead 131 to a second lead 132 of the welding machine 130 via the at least one metal pad 311 of the first circuit board 110 and the underlying at least one metal pad 311 of the second circuit board 120. The current flow is welding the at least one metal pad 311 of the first circuit board 110 to the at least one metal pad 311 of the second circuit board 120 resulting in a stable and robust connection of the first circuit board 110 with the second circuit board 120.

The first circuit board 110 can be placed directly on top of the second circuit board 120 without any intermediate component in between.

The welding may comprise resistive or inductive welding.

The leads electrically contact the metal pads via access holes 320 (see Figure 3c), in particular circular access holes 320 in the cover layers 330 of the respective circuit board 110, 120. The access holes 320 can be fitted to a shape of the respective leads 131, 132 of the welding machine 130. These access holes 320 may have been fabricated during production process of the circuit boards 110, 120.

A size of the access holes 320 may be the same or different for two of the access holes 320.

Placing the first circuit board 110 on top of the second circuit board 120 may comprises: placing a bottom surface of the first circuit board 110 on a top surface of the second circuit board 120.

By using the above-described method 410, an assembly 300 of a first circuit board 110 electrically connected to a second circuit board 120 as shown in Figure 1 can be obtained.

In such an assembly 300, the first circuit board 110 can be a flexible circuit board and the second circuit board 120 can be a flexible or rigid circuit board.

Such assembly 300 may comprise: at least one welding connection between at least one metal pad 311 (see Figure 3b, 3c) of the second circuit board 120 and at least one metal pad 311 (see Figure 3b, 3c) of the first circuit board 110, wherein the at least one metal pad 311 of the first circuit board 110 is overlaying the at least one metal pad 311 of the second circuit board 120.

Fig. 4b shows a schematic diagram of a method 420 for electrical connection of a first circuit board to a second circuit board by double-side welding according to the disclosure.

The method 420 is based on the scenario shown in Figure 2 where a double-side welding machine 130 is used for double-side welding 200.

The method 420 comprises: providing 421 a first circuit board 110 (see Figure 2) comprising at least one metal layer 310 (as shown in Figure 3a) embedded within a plurality of cover layers 330 (see Figure 3a, named here as coverlay 330), the at least one metal layer 310 comprising at least one metal pad 311 (as shown in Figure 3b) for an electrical connection of the first circuit board 110.

The method 420 comprises: providing 422 a second circuit board 120 (see Figure 2) comprising at least one metal layer 310 (as shown in Figure 3a) embedded within a plurality of cover layers 330 (see Figure 3a, named here as coverlay 330), the at least one metal layer 310 comprising at least one metal pad 311 (as shown in Figure 3b) for an electrical connection of the second circuit board 120. The first circuit board 110 and the second circuit board 120 are such that the at least one metal pad 311 of the first circuit board 110 is overlying the at least one metal pad 311 of the second circuit board 120 when the first circuit board 110 is placed on top of the second circuit board 120.

The method 420 comprises: placing 423 the first circuit board 110 on top of the second circuit board 120.

The method 420 comprises: electrically connecting 424 two leads 131, 132 of a welding machine 130 (see Figure 2) to part 312 of the at least one metal pad 311 on top of the first circuit board 110 and part 313 of the at least one metal pad 311 on bottom of the second circuit board 120.

Instead of part 312 of metal pad 311 on top of first circuit board 110 as shown in Figure 3c, also part 313 of metal pad 311 on top of first circuit board 110 can be used. Both of them (312, 313) can be used as well. A minimum requirement is to use one of the metal pads, i.e., any one of the pads 312, 313 on top of first circuit board (upper PCB). The same holds for the second circuit board 120: Instead of part 313 of metal pad 311 on bottom of second circuit board 120 as shown in Figure 3c, also part 312 of metal pad 311 on bottom of second circuit board 120 can be used. Both of them (312, 313) can be used as well. A minimum requirement is also here to use one of the metal pads, i.e., any one of the pads 312, 313 on bottom of second circuit board (bottom PCB) which corresponds to the applied pad or pads on top of first circuit board. For example, with reference to Figure 3c, use any of 312, 313 of upper PCB 110 and corresponding one/ones from bottom PCB 120. Following alternatives can be applied: 1) use 312 from upper PCB 110 with 313 from bottom PCB 120; 2) use 313 from upper PCB 110 with 312 from bottom PCB 120; or 3) use 312 and 313 from upper PCB 110 with 312 and 313 from bottom PCB 120.

The method 420 comprises: welding 425 the at least one metal pad 311 of the first circuit board 110 to the at least one metal pad 311 of the second circuit board 120 by activating the welding machine 130. Activating the welding machine results in a current flowing from the first lead 131 to the second lead 132 via the first and second circuit boards 110, 120. This results in a welding connection between the first and second circuit boards 110, 120.

Activating the welding machine 130 enables a temporary current flow from a first lead 131 to a second lead 132 of the welding machine 130 via the at least one metal pad 311 of the first circuit board 110 and the at least one metal pad 311 of the second circuit board 120. The current flow is welding the at least one metal pad 311 of the first circuit board 110 to the at least one metal pad 311 of the second circuit board 120 resulting in a stable and robust connection of the first circuit board 110 with the second circuit board 120.

As already described above with respect to Figure 4a, the first circuit board 110 can be placed directly on top of the second circuit board 120 without any intermediate component in between.

The welding may comprise resistive or inductive welding.

The leads electrically contact the metal pads via access holes 320 (see Figure 3c), in particular circular access holes 320 in the cover layers 330 of the respective circuit board 110, 120. The access holes 320 can be fitted to a shape of the respective leads 131, 132 of the welding machine 130. These access holes 320 may have been fabricated during production process of the circuit boards 110, 120.

A size of the access holes 320 may be the same or different for two of the access holes 320.

Placing the first circuit board 110 on top of the second circuit board 120 may comprises: placing a bottom surface of the first circuit board 110 on a top surface of the second circuit board 120.

By using the above-described method 420, an assembly 300 of a first circuit board 110 electrically connected to a second circuit board 120 as shown in Figure 2 can be obtained.

In such an assembly 300, the first circuit board 110 can be a flexible circuit board and the second circuit board 120 can be a flexible circuit board.

Such assembly 300 may comprise: at least one welding connection between at least one metal pad 311 (see Figure 3b, 3c) of the second circuit board 120 and at least one metal pad 311 (see Figure 3b, 3c) of the first circuit board 110, wherein the at least one metal pad 311 of the first circuit board 110 is overlaying the at least one metal pad 311 of the second circuit board 120.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims and their equivalents, the invention may be practiced otherwise than as specifically described herein.

### LISTING OF REFERENCE SIGNS

- 100: single-side welding
- 110: first circuit board, first PCB
- 120: second circuit board, second PCB
- 130: welding machine
- 131: first lead of welding machine
- 132: second lead of welding machine
- 133a, 133b: directions of movement of the leads for double-side welding
- 133c: directions of movement of the leads for single-side welding

- 200: double-side welding

- 300: assembly of first circuit board connected to second circuit board
- 310: metal layers, e.g. made of Copper
- 330: plurality of cover layers, coverlay
- 320: opening in coverlay for direct copper access
- 311: metal pads
- 111: surface mating to second PCB
- 112: opposite side to surface mated to second PCB
- 312: exposed first parts of metal pad
- 313: exposed second parts of metal pad

- 410: method for electrical connection of a first circuit board to a second circuit board by single-side welding
- 411-415: steps of method 410
- 420: method for electrical connection of a first circuit board to a second circuit board by double-side welding
- 421-425: steps of method 420

## Claims

1. A method (410) for electrical connection of a first circuit board (110) to a second circuit board (120) by single-side welding, the method comprising:
providing (411) a first circuit board (110) comprising at least one metal layer (310) embedded within a plurality of cover layers (330), the at least one metal layer (310) comprising at least one metal pad (311) for an electrical connection of the first circuit board (110);
providing (412) a second circuit board (120) comprising at least one metal layer (310) embedded within a plurality of cover layers (330), the at least one metal layer (310) comprising at least one metal pad (311) for an electrical connection of the second circuit board (120);
wherein the at least one metal pad (311) of the first circuit board (110) is overlying the at least one metal pad (311) of the second circuit board (120) when the first circuit board (110) is placed on top of the second circuit board (120);
placing (413) the first circuit board (110) on top of the second circuit board (120);
electrically connecting (414) two leads (131, 132) of a welding machine (130) to a first part (312) and a second part (313) of the at least one metal pad (311) of the first circuit board (110); and
welding (415) the at least one metal pad (311) of the first circuit board (110) to the at least one metal pad (311) of the second circuit board (120) by activating the welding machine (130).

2. A method (420) for electrical connection of a first circuit board (110) to a second circuit board (120) by double-side welding, the method comprising:
providing (421) a first circuit board (110) comprising at least one metal layer (310) embedded within a plurality of cover layers (330), the at least one metal layer (310) comprising at least one metal pad (311) for an electrical connection of the first circuit board (110);
providing (422) a second circuit board (120) comprising at least one metal layer (310) embedded within a plurality of cover layers (330), the at least one metal layer (310) comprising at least one metal pad (311) for an electrical connection of the second circuit board (120);
wherein the at least one metal pad (311) of the first circuit board (110) is overlying the at least one metal pad (311) of the second circuit board (120) when the first circuit board (110) is placed on top of the second circuit board (120);
placing (423) the first circuit board (110) on top of the second circuit board (120);
electrically connecting (424) two leads (131, 132) of a welding machine (130) to part of the at least one metal pad (311) on top of the first circuit board (110) and part of the at least one metal pad (311) on bottom of the second circuit board (120); and
welding (425) the at least one metal pad (311) of the first circuit board (110) to the at least one metal pad (311) of the second circuit board (120) by activating the welding machine (130).

3. The method (410) of claim 1,
wherein activating the welding machine (130) enables a temporary current flow from a first lead (131) to a second lead (132) of the welding machine (130) via the at least one metal pad (311) of the first circuit board (110) and the underlying at least one metal pad (311) of the second circuit board (120), the current flow welding the at least one metal pad (311) of the first circuit board (110) to the at least one metal pad (311) of the second circuit board (120).

4. The method (420) of claim 2,
wherein activating the welding machine (130) enables a temporary current flow from a first lead (131) to a second lead (132) of the welding machine (130) via the at least one metal pad (311) of the first circuit board (110) and the at least one metal pad (311) of the second circuit board (120), the current flow welding the at least one metal pad (311) of the first circuit board (110) to the at least one metal pad (311) of the second circuit board (120).

5. The method (410, 420) of any of the preceding claims,
wherein the first circuit board (110) is placed directly on top of the second circuit board (120) without any intermediate component in between.

6. The method (410, 420) of any of the preceding claims,
wherein the welding comprises resistive or inductive welding.

7. The method (410, 420) of any of the preceding claims,
wherein the leads (131, 132) electrically contact the metal pads (311) via access holes (320), in particular circular access holes (320) in the cover layers (330) of the respective circuit board (110, 120), the access holes (320) being fitted to a shape of the respective leads (131, 132) of the welding machine (130).

8. The method (410, 420) of claim 7,
wherein a size of the access holes (320) is same or different for two of the access holes (320).

9. The method (410, 420) of any of the preceding claims,
wherein placing the first circuit board (110) on top of the second circuit board (120) comprises:
placing a bottom surface of the first circuit board (110) on a top surface of the second circuit board (120).

10. An assembly (300) of a first circuit board (110) electrically connected to a second circuit board (120), the assembly (300) being obtained by a method according to any of the previous claims.

11. The assembly (300) of claim 10,
wherein the first circuit board (110) is a flexible circuit board; and
wherein the second circuit board (120) is a flexible or rigid circuit board.

12. The assembly (300) of claim 10 or 11, comprising:
at least one welding connection between at least one metal pad (311) of the second circuit board (120) and at least one metal pad (311) of the first circuit board (110) which is overlaying the at least one metal pad (311) of the second circuit board (120).
